Europäisches Patentamt

European Patent Office

Office européen des brevets

(19)

(11) Veröffentlichungsnummer: **0 322 607 B1**

(12) **EUROPÄISCHE PATENTSCHRIFT**

(45) Veröffentlichungstag der Patentschrift: **06.04.94**

(21) Anmeldenummer: **88120462.2**

(22) Anmeldetag: **07.12.88**

(51) Int. Cl.5: **G01R 1/067**, G01R 31/302, G01R 1/073

(54) **Ansteuereinrichtung für die Vorrichtung zur elektrischen Funktionsprüfung von Verdrahtungsfeldern.**

(30) Priorität: **21.12.87 DE 3743390**

(43) Veröffentlichungstag der Anmeldung:
**05.07.89 Patentblatt 89/27**

(45) Bekanntmachung des Hinweises auf die
Patenterteilung:
**06.04.94 Patentblatt 94/14**

(84) Benannte Vertragsstaaten:
**AT BE CH DE FR GB IT LI LU NL SE**

(56) Entgegenhaltungen:
**EP-A- 0 107 771**
**EP-A- 0 216 135**
**EP-A- 0 218 058**

**IBM TECHNICAL DISCLOSURE BULLETIN,
Band 27, Nr. 4A, September 1984, Seiten
2024-2025, New York, US; T. BAYER et al.:
"Open/short testing"**

**IBM TECHNICAL DISCLOSURE BULLETIN,
Band 29, Nr. 1, Juni 1986, Seiten 305-307,
New York, US; "Gas discharge device to test
for signal plane to signal plane incipient
shorts in drilled but unplated circuit cards
and boards"**

(73) Patentinhaber: **SIEMENS AKTIENGESELL-
SCHAFT
Wittelsbacherplatz 2
D-80333 München(DE)**

(72) Erfinder: **Heisen, Arnold, Prof.
Königsberger Strasse 22
D-8046 Garching(DE)**
Erfinder: **Doemens, Günter, Dr.
Eichenfeldstrasse 4
D-8150 Holzkirchen(DE)**
Erfinder: **Rose, Thomas, Dr.
Maronstrasse 6
D-8000 München 70(DE)**
Erfinder: **Hoffmann, Detlef, Dipl.-Phys.
Kronberger Weg 3
D-8000 München 60(DE)**

EP 0 322 607 B1

**Beschreibung**

Die Erfindung betrifft eine Ansteuereinrichtung für eine Vorrichtung zur elektrischen Funktionsprüfung von Verdrahtungsfeldern, insbesondere von Leiterplatten, nach dem Oberbegriff des Anspruchs 1 oder nach dem Oberbegriff des Anspruchs 7.

Aus der EP-A-0 102 565 ist eine Vorrichtung für die elektrische Funktionsprüfung von Verdrahtungsfeldern bekannt, bei welcher die bisher übliche ohm'sche Kontaktierung der Meßstellen durch eine berührungslose Plasmakontaktierung über Gasentladungsstrecken ersetzt wird. Hierzu werden in eine auf die Verdrahtungsfelder aufsetzbare Trägerplatte eine Vielzahl von mit Elektroden versehenen Gasentladungskanälen eingebracht, wobei die im Rahmen der Verdrahtungsfelder angeordneten Gasentladungskanäle zu den Meßstellen hin offen sind. Sind nun zwei ausgewählte Meßstellen beispielsweise durch eine Leiterbahn elektrisch leitend miteinander verbunden, so bilden die zugeordneten Gasentladungskanäle zwei in Reihe geschaltete Gasentladungsstrecken, die durch Anlegen einer hinreichend hohen Spannung an die Elektroden gezündet werden können. Mit der Zündung der Gasentladungen erfolgt dann ein Stromtransport, der zu Prüfzwecken ausgewertet werden kann. Unterbleibt die Zündung der Gasentladung oder fließt nach einer Zündung ein zu geringer Strom, so kann auf eine unterbrochene oder von vornherein nicht existierende Verbindung zwischen den ausgewählten Meßstellen geschlossen werden. Die bekannte Vorrichtung ermöglicht also Leitfähigkeits- und Isolationsmessungen, wobei durch das Vermeiden von ohm'schen Kontakten eine sehr hohe Zuverlässigkeit erreicht wird.

In Prüfautomaten und Prüfadaptern für unbestückte und bestückte Leiterplatten sowie für Verdrahtungsfelder in Löt- oder Crimptechnik kann die Anzahl der Meßstellen beispielseise Hunderttausend betragen. Mit der Anzahl der Meßstellen steigt dann sowohl beim Einsatz federnder Prüfspitzen als auch bei der ionischen Kontaktierung über Gasentladungsstrecken die Anzahl der erforderlichen Zuleitungen und Schaltelemente, wodurch ein erheblicher gerätetechnischer Aufwand und entsprechend hohe Kosten verursacht werden. Zur Verringerung der Zahl der Anschlüsse wurde in der EP-A-0 218 058 bereits eine Anordnung vorgeschlagen, bei der jeder Gasentladungskanal mit mindestens zwei Elektroden ausgerüstet und nach dem Koinzidenzprinzip über diesen Elektroden zugeordnete Elektrodensammelleitungen auswählbar ist. Hierdurch kann dann eine Matrixadressierung ausgewählter Meßstellen bzw. Gasentladungskanäle vorgenommen werden. Die Auswahl eines mit zwei Elektroden ausgerüsteten Gasentladungskanals nach dem Koinzidenzprinzip über zwei Elektrodensammelleitungen kann grundsätzlich darauf beruhen, daß das Zünden und/oder Brennen einer Gasentladung erst durch das Zusammenwirken beider Elektroden ermöglicht wird oder daß das Zünden und/oder Brennen einer Gasentladung durch eine der Elektroden verhindert wird, wobei diese Hemmwirkung durch eine Ansteuerung dieser Elektrode aufgehoben wird. In sämtlichen Fällen brennen die Gasentladungen in den angesteuerten Gasentladungskanälen zwischen einer der beiden Elektroden und der zugeordneten Meßstelle.

Aus IBM TECHNICAL DISCLOSURE BULLETIN, Band 27, Nr. 4A, September 1984, Seiten 2024-2025, New York, US ist eine Anordnung zur elektrischen Funktionsprüfung der Durchkontaktierungen von Mehrlagenleiterplatten bekannt. Diese Anordnung umfaßt eine plattenförmige, optisch transparente Masseelektrode, die in einem geringen Abstand über den Meßstellen auf der Oberseite der Mehrlagenleiterplatte angeordnet wird. Wird nun zwischen einer Kontaktierelektrode und einer Meßstelle auf der Unterseite der Mehrlagenleiterplatte eine Hochfrequenzentladung gezündet, so beginnt zwischen der zugeordneten Meßstelle auf der Oberseite und der Masseelektrode eine lokal begrenzte Entladung zu glimmen. Die eigentliche Prüfung erfolgt über eine computergesteuerte Bildauswerteeinrichtung, welche die gewünschte Lage der Glimmentladung mit der tatsächlichen Lage vergleicht. Im Fall einer unterbrochenen Durchkontaktierung kommt es zu keiner Glimmentladung, während im Falle eines Kurzschlusses zu viele Glimmentladungen auftreten.

Der Erfindung liegt die Aufgabe zugrunde, bei einer gattungsgemäßen Ansteuereinrichtung mit zwei Elektroden pro Gasentladungskanal möglichst einfache Elektrodenformen zu ermöglichen und so den Weg zu einer weiteren, einfachen Miniaturisierung zu öffnen.

Die Lösung dieser Aufgabe erfolgt bei der Prüfung einer elektrisch leitenden Verbindung zwischen zwei Meßstellen durch die kennzeichnenden Merkmale des Anspruchs 1 und bei der Prüfung einer Meßstelle auf Isolation gegen alle anderen Leiterbahnen durch die kennzeichnenden Merkmale des Anspruchs 7.

Nach der Erfindung wird zur Ansteuerung eines Testpunktes zwischen den dazugehörigen beiden Elektroden eine Steuergasentldung gezündet. Soll zwischen zwei Testpunken die elektrische Verbindung geprüft werden, so werden die entsprechenden beiden Steuergasentladungen auf zueinander unterschiedliches Potential gelegt. Dadurch wird bei vorhandener elektrischer Verbindung ein Stromfluß von der einen Gasentladung über die Verbindung zur zweiten Gasentladung hervorgerufen, der zu Prüfzwecken ausgewertet werden kann.

Mit der Ansteuereinrichtung nach der Erfindung hat man eine größere Wahlfreiheit in der Gestaltung der Elektrodenform.

Gemäß Anspruch 2 bestehen die Elektrodensammelleitungen vorzugsweise aus einem elektrisch leitenden Draht oder Band. Hierdurch können die Elektroden mit minimalem Aufwand realisiert werden.

Die Weiterbildung nach Anspruch 3 betrifft die Anordnung der ersten Elektroden und der zweiten Elektroden in verschiedenen Höhenlagen der Gasentladungskanäle.

Sind die ersten Elektrodensammelleitungen und die zweiten Elektrodensammelleitungen gemäß Anspruch 4 so angeordnet, daß sie sich kreuzen, so lassen sich beide Scharen von Sammelleitungen besonders vorteilhaft verlegen.

Gemäß Anspruch 5 ist es im Hinblick auf einen vielseitigen Einsatz der erfindungsgemäßen Ansteuereinrichtung besonders günstig, wenn die Gasentladungskanäle in einem in der Leiterplattentechnik üblichen Rasterung angeordnet sind.

Gemäß Anspruch 6 ist die gesamte Testvorrichtung gegenüber dem zu testenden Verdrahtungsfeld um 90° drehbar, so daß die Tests zur sicheren Erfassung sämtlicher Meßstellen in der nicht gedrehten und in der gedrehten Position durchgeführt werden können.

Die Erfindung wird anhand der Figuren erläutert. Es zeigen:

Figur 1 das Prinzip einer Ansteuereinrichtung zur elektrischen Funktionsprüfung und

Figur 2 sechs ausgewählte Testpunkte mit Ansteuerelektroden.

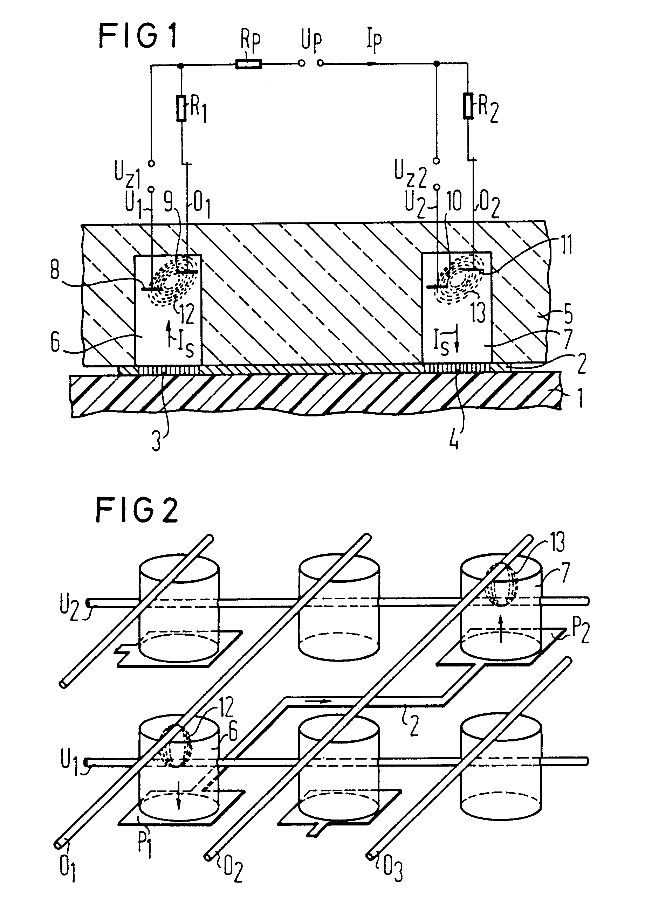

Die Figur 1 zeigt in stark vereinfachter schematischer Darstellung die Wirkungsweise einer Ansteuerinrichtung für eine Vorrichtung zur elektrischen Funktionsprüfung von Verdrahtungsfeldern, insbesondere von Leiterplatten, auf der Basis einer berührungslosen Plasmakontaktierung der Meßstellen (Testpunkte). In dieser Figur ist ein Teil einer Leiterplatte 1 zu erkennen, auf deren Oberseite die Enden einer Leiterbahen 2 Meßstellen 3 und 4 bilden. Auf der Oberseite der Leiterplatte 1 ist eine Trägerplatte 5 aus einem isolierenden Material, zum Beispiel Glas, aufgesetzt, in die in Form von Sacklöchern eine Vielzahl von Gasentladungskanälen eingebracht sind. In der Zeichnung sind dabei nur der der Meßstelle 3 zugeordnete Gasentladungskanal 6 und der der Meßstelle 4 zugeordnete Gasentladungskanal 7 dargestellt. In dem Gasentladungskanal 6 sind Elektroden 8 und 9 angeordnet, wobei die Elektrode 8 tiefer liegen kann als die Elektrode 9. In dem Gasentladungskanal 7 sind Elektroden 10, 11 angeordnet, wobei wiederum die Elektrode 10 tiefer, das heißt auf gleicher Höhe mit der Elektrode 8, liegen kann. Mit den gepunkteten Linien 12, 13 zwischen den Elektroden ist die Gasentladung angedeutet. Mit $O_1$ und $O_2$ sind die zugehörigen oberen Sammelleitungen bezeichnet und mit $U_1$ und $U_2$ die unteren Sammelleitungen. $U_{z1}$ und $U_{z2}$ bezeichnen gleiche oder verschiedene Steuerspannungen, welche die Steuergasentladungen in den Kanälen auslösen. Mit $U_P$ ist eine Prüfspannung und mit $I_P$ ein Prüfstrom bezeichnet. $R_1$, $R_2$ und $R_p$ bezeichnen Vorwiderstände, mit denen die gewünschten Arbeitspunkte einzustellen sind.

In der Figur 2 sind mit $O_1$ bis $O_3$ ebenfalls die oberen Elektrodensammelleitungen und $U_1$ und $U_2$ die unteren Elektrodensammelleitungen bezeichnet. P1 und P2 markieren zwei Testpunkte (Meßstellen) auf der Leiterbahn.

Sollen zum Beispiel in Figur 2 die Testpunkte $P_1$ und $P_2$ untersucht werden, so werden zunächst folgende Spannungen angelegt:

| Elektrode | Spannung |
|---|---|
| $U_1$ | 0 |
| $U_2$ | $U_{z2}$ |
| $O_1$ | $U_{z1}$ |
| $O_2$ | 0 |

Somit liegt an den Elektroden über $P_1$ und $P_2$ eine Spannung $U_{z1}$ bzw. $U_{z2}$, die die Zündung einer Gasentladung bewirkt. An den Kreuzungspunkten von $O_1$ und $U_2$ und von $O_2$ und $U_1$ herrscht keine oder nur eine geringe Potentialdifferenz. Wird nun die Spannung zum Beispiel an $U_1$ und $O_1$ um den gleichen Betrag $U_P$ geändert, so ändern sich die Spannungsdifferenzen über $P_1$ bzw. $P_2$ nicht, aber zwischen $P_1$ und $P_2$ wird eine Potentialdifferenz erzeugt, die bei leitender Verbindung zwischen beiden einen Stromfluß von den Gasentladungen über die Leiterbahn bewirkt. Dabei muß $U_P < U_{z1, 2}$ sein, weil sonst an ungewünschten Stellen Gasentladungen gezündet werden.

Beim Test einer Leiterplatte mit N Leiterbahnen (und der Einfachheit halber genau zwei zu testenden Endpunkten pro Bahn) werden für den "Durchgangstest" N Messungen benötigt. Müßte beim Isolationstest jede Leiterbahn gegen jede andere einzeln auf Kurz- oder Nebenschlüsse geprüft werden, wären 1/2 N (N-1) Messungen notwendig. Die Konsequenz wären sehr lange Meßzeiten.

Da eine Parallelschaltung vieler Steuergasentladungen physikalisch nicht möglich ist, läßt sich mit dem bisher beschriebenen Verfahren die Isolation einer Leiterbahn gegen alle anderen nicht gleichzeitig testen.

Mit der oben beschriebenen Anordnung läßt sich jedoch mit dem im folgenden beschriebenen Verfahren der Test "einer gegen alle" verwirklichen, bei dem die Isolierungsprüfung einer Leiterbahn gegen alle anderen in einem Schritt möglich ist. Dann benötigt auch der Isolationstest nur N Messungen.

Soll zum Beispiel $P_1$ auf Isolation gegen alle anderen Leiterbahnen geprüft werden, so wird zwischen $U_1$ einerseits und allen anderen unteren Elektroden $U_i$, die über zu testenden Punkten und nicht über der zu $P_1$ gehörenden Leiterbahn liegen, andererseits eine Spannung angelegt, die zwar zum Unterhalt einer bereits brennenden Gasentladung, aber nicht zu einer eigenständigen Zündung ausreicht. Wird dann an $O_1$ eine Spannung angelegt von einer Größe und Polarität, die eine Zündung nur zwischen $O_1$ und $U_1$ und nirgends sonst ermöglicht, so wird zwischen den Elektroden über $P_1$ eine Gasentladung gezündet. Dies bewirkt einen Stromstoß zum Testpunkt $P_1$ und so zu jedem damit leitend verbundenen Punkt $P_i$. Dies verursacht eine Zündung zwischen dem Testpunkt $P_i$ und der darüber befindlichen unteren Elektrode. Auf diese Weise kann eine (unerwünschte) leitende Verbindung zwischen dem fest ausgewählten Testpunkt $P_1$ und einem anderen, vorher nicht spezifizierten Punkt $P_i$ festgestellt werden. Bei N Leiterbahnen benötigt man also auch nur N-Isolationsmessungen. Bei Bedarf kann dieser Kurzschluß dann durch weitere Messungen lokalisiert werden, bei denen $P_1$ nicht mehr gegen alle, sondern gegen die Hälfte (ein Viertel, usw.) der Testpunkte auf Kurzschluß geprüft wird. Die zusätzliche Anzahl von Messungen entspricht dann ungefähr dem Zweierlogarithmus aus der Leiterbahnanzahl 1d (N).

Beispiel:

Bei der in Fig. 2 dargestellten Ausführungsform wurde für die oberen Elektrodensammelleitungen $O_1$, $O_2$ und $O_3$ und für die unteren Elektrodensammelleitungen $U_1$ und $U_2$ ein Aluminiumdraht mit einem Durchmesser von 3 mm verwendet. Der Abstand zwischen der Ebene mit den oberen Elektrodensammelleitungen und der Ebene mit den unteren Elektrodensammelleitungen betrug dabei 25 mm. Der Abstand zwischen den Drahtachsen der unteren Elektrodensammelleitungen und der Ebene mit der Leiterbahn 2 und den Testpunkten $P_1$ und $P_2$ betrug 10 mm. Der Durchmesser der Gasentladungskanäle 6 und 7 sowie der anderen nicht bezeichneten Gasentladungskanäle betrug 3 mm. Die gesamte Anordnung befand sich dabei in eine Heliumatmospähre mit einem Druck von 25 mbar.

Die Prüfung erfolgte mit folgenden elektrischen Parametern, wobei die Bezeichnungen teilweise der Fig. 1 zu entnehmen sind.

Vorwiderstand $R_1$ = 400 kΩ

Vorwiderstand $R_2$ = 400 kΩ

Vorwiderstand $R_p$ = 10 kΩ

Brennspannung zwischen $U_1$ und $O_1$ (potentialfrei) 450 V, $U_1$ positiv gegen $O_1$, Brennstrom 1,3 mA

Brennspannung zwischen $U_2$ und $O_2$ (potentialfrei) 450 V, $U_2$ negativ gegen $O_2$, Brennstrom 1,3 mA

Prüfspannung zwischen $U_1$ und $U_2$ (potentialfrei) 200 V, $U_2$ positiv gegen $U_1$

Bei einer elektrisch leitenden Verbindung zwischen den Testpunkten $P_1$ und $P_2$ über die Leiterbahn 2 wurde ein Prüfstrom $I_p$ = 0,6 mA gemessen. Mit einer unterbrochenen Leiterbahn 2 betrug der Prüfstrom $I_p$ demgegenüber $I_p$ = 0.

**Patentansprüche**

**1.** Ansteuereinrichtung für eine Vorrichtung Zur elektrischen Funktionsprüfung von Verdrahtungsfeldern, insbesondere von Leiterplatten (1), mit einer auf die Verdrahtungsfelder aufsetzbaren Trägerplatte (5), in welche eine Vielzahl von mit Elektroden (8, 9, 10, 11) versehenen Gasentladungskanälen (6, 7) eingebracht sind, wobei jeweils mindestens zwei ausgewählte Meßstellen (3, 4; P1, P2) eines Verdrahtungsfeldes über die zugeordneten Gasentladungskanäle (6, 7) und deren Elektroden (8, 9, 10, 11) vorzugsweise durch ein Plasma kontaktierbar sind, wobei jeder Gasentladungskanal (6, 7) mit mindestens zwei Elektroden (8, 9, 10, 11) ausgerüstet und nach dem Koinzidenzprinzip über diesen Elektroden (8, 9, 10, 11) zugeordnete Elektrodensammelleitungen ($U_1$, $O_1$, $U_2$, $O_2$) auswählbar ist und erste Elektroden (9, 11) der Gasentladungskanäle (6, 7) reihenweise über erste Elektrodensammelleitungen ($O_1$, $O_2$) miteinander verbunden sind und zweite Elektroden (8, 10) der Gasentladungskanäle (6,

EP 0 322 607 B1

7) reihenweise über zweite Elektrodensammelleitungen ($U_1$, $U_2$) miteinander verbunden sind,
**dadurch gekennzeichnet,**
daß an die erste Elektrodensammelleitung ($O_1$) und an die zweite Elektrodensammelleitung ($U_1$) des ersten ausgewählten Gasentladungskanals (6) eine Spannung ($U_{z1}$) angelegt ist, die ausreichend ist um eine erste Steuergasentladung (12) zwischen diesen Elektrodensammelleitungen ($O_1$, $U_1$) in dem ersten ausgewählten Gasentladungskanal (6) zu zünden und daß ferner an die erste Elektrodensammelleitung ($O_2$) und an die zweite Elektrodensammelleitung ($U_2$) des zweiten ausgewählten Gasentladungskanals (7) eine Spannung ($U_{z2}$) angelegt ist, die ausreichend ist, um eine zweite Steuergasentladung (13) zwischen diesen Elektrodenleitungen ($O_2$, $U_2$) in dem zweiten ausgewählten Gasentladungskanal (7) zu zünden und daß zum Test auf eine leitende Verbindung zwischen den beiden ausgewählten Gasentladungskanälen (6, 7) zwischen den Steuergasentladungen (12, 13) eine Potentialdifferenz ($U_p$) angelegt ist, die bei leitender Verbindung einen Stromfluß ($I_p$) von der ersten Steuergasentladung (12) über die leitende Verbindung zu der zweiten Steuergasentladung (13) bewirkt.

2. Ansteuereinrichtung nach Anspruch 1,
**dadurch gekennzeichnet,**
daß die Elektroden (8, 9, 10, 11) und die Elektrodensammelleitungen ($O_1$ - $O_n$, $U_1$ - $U_m$) aus einem elektrisch leitenden Draht oder Band bestehen.

3. Ansteuereinrichtung nach Anspruch 1 oder 2,
**dadurch gekennzeichnet,**
daß die ersten Elektroden (9, 11) und die zweiten Elektroden (8, 10) in verschiedenen Höhenlagen der Gasentladungskanäle (6, 7) angeordnet sind.

4. Ansteuereinrichtung nach Anspruch 1, 2 oder 3,
**dadurch gekennzeichnet,**
daß die ersten Elektrodensammelleitungen ($O_1$ - $O_n$) und die zweiten Elektrodensammelleitungen ($U_2$ - $U_m$) sich kreuzend angeordnet sind.

5. Ansteuereinrichtung nach eimem der Ansprüche 1 bis 4,
**dadurch gekennzeichnet,**
daß die Gasentladungskanäle (6, 7) in einem in der Leiterplattentechnik üblichen Rastermaß angeordnet sind.

6. Ansteuereinrichtung nach einem der Ansprüche 1 bis 5,
**dadurch gekennzeichnet,**
daß die ganze Testvorrichtung gegenüber dem zu testenden Verdrahtungsfeld um 90° drehbar ist und daß die Tests in der nicht gedrehten und in der gedrehten Position durchführbar sind.

7. Ansteuervorrichtung für eine Vorrichtung zur elektrischen Funktionsprüfung von Verdrahtungsfeldern, insbesondere von Leiterplatten (1), mit einer auf die Verdrahtungsfelder aufsetzbaren Trägerplatte (5), in welche eine Vielzahl von mit Elektroden (8, 9, 10, 11) versehenen Gasentladungskanälen (6, 7) eingebracht sind, wobei jeweils mindestens zwei ausgewählte Meßstellen (3, 4; P1, P2) eines Verdrahtungsfeldes über die zugeordneten Gasentladungskanäle (6, 7) und deren Elektroden (8, 9, 10, 11) vorzugsweise durch ein Plasma kontaktierbar sind, wobei jeder Gasentladungskanal (6, 7) mit mindestens zwei Elektroden (8, 9, 10, 11) ausgerüstet und nach dem Koinzidenzprinzip über diesen Elektroden (8, 9, 10, 11) zugeordnete Elektrodensammelleitungen ($U_1$, $O_1$, $U_2$, $O_2$) auswählbar ist und erste Elektroden (9, 11) der Gasentladungskanäle (6, 7) reihenweise über erste Elektrodensammelleitungen ($O_1$, $O_2$) miteinander verbunden sind und zweite Elektroden (8, 10) der Gasentladungskanäle (6, 7) reihenweise über zweite Elektrodensammelleitungen ($U_1$, $U_2$) miteinander verbunden sind,
**dadurch gekennzeichnet,**
daß zur Prüfung einer Meßstelle (3; P1) auf Isolation gegen alle anderen Leiterbahnen an die erste obere Elektrodensammelleitung ($O_1$) und die zweite untere Elektrodensammelleitung ($U_1$) des der Meßstelle (3; P1) zugeordneten Gasentladungskanals (6) eine Spannung ($U_{z1}$) angelegt ist, die ausreichend ist um eine Steuergasentladung (12) zwischen diesen Elektrodensammelleitungen ($O_1$, $U_1$) in dem der Meßstelle (3; P1) zugeordneten Gasentladungskanal (6) zu zünden und daß zwischen allen unteren Elektrodensammelleitungen ($U_1$ bis $U_m$) einerseits, die über zu testenden Meßstellen und nicht über der zur ausgewählten Meßstelle (3; P1) gehörenden Leiterbahn liegen, und der Steuergasentla-

5

dung (12) andererseits eine Spannung ($U_p$) angelegt ist, die bei bestehender leitender Verbindung zwischen der ausgewählten Meßstelle (3; P1) und irgendeiner anderen Meßstelle ($P_2$ bis $P_n$) ausreicht, um eine Gasentladung zwischen der dazugehörenden unteren Elektrodensammelleitung und der Meßstelle zu zünden, so daß ein Stromfluß von der entsprechenden Elektrode über die Gasentladung und die leitende Verbindung zur Steuergasentladung (12) bewirkt wird.

**Claims**

1. Drive device for a device for the electrical functional testing of wiring panels, preferably of printed-circuit boards (1), having a carrier board (5) which can be placed onto the wiring panels and in which a multiplicity of gas-discharge channels (6, 7) are incorporated which are provided with electrodes (8, 9, 10, 11), it being possible to make contact with in each case at least two selected measurement points (3, 4; P1, P2) of a wiring panel via the associated gas-discharge channels (6, 7) and their electrodes (8, 9, 10, 11), preferably by means of a plasma, each gas-discharge channel (6, 7) being equipped with at least two electrodes (8, 9, 10, 11) and it being possible to select associated electrode busbars ($U_1$, $O_1$, $U_2$, $O_2$) in accordance with the coincidence principle via these electrodes (8, 9, 10, 11), and first electrodes (9, 11) of the gas-discharge channels (6, 7) being connected to one another in series via first electrode busbars ($O_1$, $O_2$) and second electrodes (8, 10) of the gas-discharge channels (6, 7) being connected to one another in series via second electrode busbars ($U_1$, $U_2$), characterised in that a voltage ($U_{z1}$) is applied to the first electrode busbar ($O_1$) and to the second electrode busbar ($U_1$) of the first selected gas-discharge channel (6), which voltage ($U_{z1}$) is sufficient to trigger a first control gas discharge (12) between these electrode busbars ($O_1$, $U_1$) in the first selected gas-discharge channel (6), and in that, furthermore, a voltage ($U_{z2}$) is applied to the first electrode busbar ($O_2$) and to the second electrode busbar ($U_2$) of the second selected gas-discharge channel (7), which voltage ($U_{z2}$) is sufficient to trigger a second control gas discharge (13) between these electrode lines ($O_2$, $U_2$) in the second selected gas-discharge channel (7), and in that a potential difference ($U_p$) is applied, for testing, to a conductive connection between the two selected gas-discharge channels (6, 7) between the control gas discharges (12, 13), which potential difference ($U_p$), in the case of a conductive connection, causes a current flow ($I_p$) from the first control gas discharge (12) via the conductive connection to the second control gas discharge (13).

2. Drive device according to Claim 1, characterised in that the electrodes (8, 9, 10, 11) and the electrode busbars ($O_1$-$O_n$, $U_1$-$U_m$) comprise an electrically conductive wire or strip.

3. Drive device according to Claim 1 or 2, characterised in that the first electrodes (9, 11) and the second electrodes (8, 10) are arranged at different height positions in the gas-discharge channels (6, 7).

4. Drive device according to Claim 1, 2 or 3, characterised in that the first electrode busbars ($O_1$-$O_n$) and the second electrode busbars ($U_2$-$U_m$) are arranged in a mutually crossing manner.

5. Drive device according to one of Claims 1 to 4, characterised in that the gas-discharge channels (6, 7) are arranged in a grid size which is normal in printed-circuit board technology.

6. Drive device according to one of Claims 1 to 5, characterised in that the entire test device can be rotated through 90° with respect to the wiring panel to be tested, and in that the tests can be carried out in the non-rotated position and in the rotated position.

7. Drive device for a device for the electrical functional testing of wiring panels, preferably of printed-circuit boards (1), having a carrier board (5) which can be placed onto the wiring panels and in which a multiplicity of gas-discharge channels (6, 7) are incorporated which are provided with electrodes (8, 9, 10, 11), it being possible to make contact with in each case at least two selected measurement points (3, 4; P1, P2) of a wiring panel via the associated gas-discharge channels (6, 7) and their electrodes (8, 9, 10, 11), preferably by means of a plasma, each gas-discharge channel (6, 7) being equipped with at least two electrodes (8, 9, 10, 11) and it being possible to select associated electrode busbars ($U_1$, $O_1$, $U_2$, $O_2$) in accordance with the coincidence principle via these electrodes (8, 9, 10, 11), and first electrodes (9, 11) of the gas-discharge channels (6, 7) being connected to one another in series via first electrode busbars ($O_1$, $O_2$) and second electrodes (8, 10) of the gas-discharge channels (6, 7) being connected to one another in series via second electrode busbars ($U_1$, $U_2$), characterised in that a voltage ($U_{z1}$) is applied to the first upper electrode busbar ($O_1$) and to the second lower electrode busbar ($U_1$) of the gas-discharge channel (6) associated with a measurement point (3; P1) in order to test said measurement point (3; P1) for insulation from all the other conductor tracks, which voltage ($U_{z1}$) is sufficient to trigger a control gas discharge (12) between these electrode busbars ($O_1$, $U_1$) in the gas-discharge channel (6) associated with the measurement point (3; P1), and in that a voltage ($U_p$) is applied between all the lower electrode busbars ($U_1$ to $U_m$) on the one hand, which are located above measurement points to be tested and not above the conductor track associated with the selected measurement point (3; P1), and the control gas discharge (12) on the other hand, which voltage ($U_p$) is sufficient when a conductive connection exists between the selected measurement point (3; P1) and any other measurement point ($P_2$ to $P_n$) to trigger a gas discharge between the associated lower electrode busbar and the measurement point, so that a current flow is produced from the corresponding electrode, via the gas discharge and the conductive connection, to the control gas discharge (12).

**Revendications**

1. Dispositif de commande pour un dispositif servant à tester le fonctionnement électrique de zones de câblage, notamment de plaquettes à circuits imprimés (1), comportant une plaque de support (5), qui peut être appliquée sur les zones de câblage et dans laquelle sont insérés une multiplicité de canaux de décharge dans un gaz (6,7) pourvus d'électrodes (8,9,10,11), et dans lequel de préférence un plasma peut venir en contact avec respectivement au moins deux points de mesure sélectionnés (3,4;P1,P2) d'une zone de câblage, par l'intermédiaire des canaux associés de décharge dans le gaz (6,7) et de leurs électrodes (8,9,10,11), chaque canal de décharge dans le gaz (6,7) est pourvu d'au moins deux électrodes (8,9,10,11) et peut être sélectionné selon le principe de coïncidence, par l'intermédiaire de lignes communes ($U_1$, $O_1$, $U_2$, $O_2$) de liaison des électrodes, qui sont associées à ces électrodes (8,9,10,11), et des premières électrodes (9,11) des canaux de décharge dans le gaz (6,7) sont raccordés entre elles en série par l'intermédiaire de premières lignes ($O_1$, $O_2$) de raccordement des électrodes, et des secondes électrodes (8,10) des canaux de décharge dans le gaz (6,7) sont reliés entre elles et en série par l'intermédiaire de secondes lignes communes ($U_1$, $U_2$) de raccordement des électrodes,

   caractérisé par le fait

   qu'à la première ligne commune ($O_1$) de raccordement des électrodes et à la seconde ligne commune ($U_1$) de raccordement des électrodes du premier canal sélectionné de décharge dans le gaz (6) est appliquée une tension ($U_{z1}$), qui est suffisante pour amorcer une première décharge dans le gaz de commande (12) entre ces lignes communes ($O_1$, $U_1$) de raccordement des électrodes, dans le premier canal sélectionné de décharge dans le gaz (6), et, qu'en outre, à la première ligne commune ($O_2$) de raccordement des électrodes et à la seconde commune ($U_2$) de raccordement des électrodes du second canal sélectionné de décharge dans le gaz (7) est appliquée une tension ($U_{z2}$) qui est suffisante pour amorcer une seconde décharge dans le gaz de commande (13) entre ces lignes ($O_2$, $U_2$) de raccordement des électrodes dans le second canal sélectionné de décharge dans le gaz (7), et que pour tester une liaison conductrice, on applique entre les deux canaux sélectionnés de décharge dans le gaz (6,7), entre les décharges de gaz de commande (12,13), une différence de potentiel ($U_p$), qui, dans le cas d'une liaison conductrice, provoque le passage d'un flux de courant ($U_p$) de la première décharge dans le gaz de commande (12) à la seconde décharge dans le gaz de commande (13), par l'intermédiaire de la liaison conductrice.

2. Dispositif de commande selon la revendication 1, caractérisé par le fait que les électrodes (8,9,10,11) et les lignes communes ($O_1$-$O_n$, $U_1$-$U_m$) de raccordement des électrodes sont constituées par un fil électriquement conducteur ou une bande électriquement conductrice.

3. Dispositif de commande suivant la revendication 1 ou 2, caractérisé par le fait que les premières électrodes (9,11) et les secondes électrodes (8,10) sont disposées dans des positions en hauteur différentes des canaux de décharge dans le gaz (6,7).

4. Dispositif de commande suivant la revendication 1, 2 ou 3, caractérisé par le fait que les premières lignes communes ($O_1$-$O_n$) de raccordement des électrodes et les secondes lignes communes ($U_2$-$U_m$) de raccordement des électrodes se croisent.

**5.** Dispositif de commande suivant l'une des revendications 1 à 4, caractérisé par le fait que les canaux de décharge dans le gaz (6,7) sont disposés avec un pas de réseau usuel dans la technique des plaquettes à circuits imprimés.

**6.** Dispositif de commande suivant l'une des revendications 1 à 5, caractérisé par le fait que l'ensemble du dispositif de test peut pivoter sur 90° par rapport à la zone de câblage à tester et que les tests doivent être exécutés dans la position non pivotée et dans la position pivotée.

**7.** Dispositif de commande pour un dispositif servant à tester le fonctionnement électrique de zones de câblage, notamment de plaquettes à circuits imprimés (1), comportant une plaque de support (5), qui peut être appliquée sur les zones de câblage et dans laquelle sont insérés une multiplicité de canaux de décharge dans un gaz (6,7) pourvus d'électrodes (8,9,10,11), et dans lequel de préférence un plasma peut venir en contact avec respectivement au moins deux points de mesure sélectionnés (3,4;P1,P2) d'une zone de câblage, par l'intermédiaire des canaux associés de décharge dans le gaz (6,7) et de leurs électrodes (8,9,10,11), chaque canal de décharge dans le gaz (6,7) est équipé d'au moins deux électrodes (8,9,10,11) et peut être sélectionné selon le principe de coïncidence, par l'intermédiaire de lignes communes ($U_1$, $O_1$, $U_2$, $O_2$) de liaison des électrodes, qui sont associées à ces électrodes (8,9,10,11), et des premières électrodes (9,11) des canaux de décharge dans le gaz (6,7) sont raccordés entre elles et en série par l'intermédiaire de premières lignes ($O_1$, $O_2$) de raccordement des électrodes, et des secondes électrodes (8,10) des canaux de décharge dans le gaz (6,7) sont reliés entre elles et en série par l'intermédiaire de secondes lignes communes ($U_1$,$U_2$) de raccordement des électrodes,
caractérisé par le fait
que pour tester un point de mesure (3;P1) pour déterminer s'il existe une isolation vis-à-vis de toutes les autres voies conductrices, on applique, à la première ligne supérieure commune ($O_1$) de raccordement des électrodes et à la seconde ligne commune inférieure ($U_1$) de raccordement des électrodes du canal de décharge dans le gaz (6) associé au point de mesure (3;P1), une tension ($U_{z1}$) qui est suffisante pour amorcer une décharge dans le gaz de commande (12) entre ces lignes communes ($O_1$, $U_1$) de raccordement des électrodes, dans le canal de décharge dans le gaz (6) associé au point de mesure (3; P1) et, qu'entre, d'une part toutes les lignes communes inférieures ($U_1$ à $U_m$) de raccordement des électrodes, qui sont situées au-dessus de points de mesure devant être testés et non au-dessus de la voie conductrice qui est associée au point de mesure sélectionné (3;P1), et, d'autre part, à la décharge dans le gaz de commande (12) est appliquée une tension ($U_p$), qui suffit, dans le cas où une liaison conductrice existe entre le point de mesure sélectionné (3;P1) ou n'importe quel autre point de mesure ($P_2$ à $P_n$), pour amorcer une décharge dans le gaz entre la ligne inférieure de raccordement des électrodes, qui y est associée, de sorte qu'un flux de courant est établi de l'électrode correspondante à la décharge dans le gaz de commande (12), par l'intermédiaire de la décharge dans le gaz et de la liaison conductrice.

8

FIG 1

FIG 2